(19) Europäisches Patentamt
European Patent Office
Office européen des brevets

(11) EP 2 671 930 A1

(12) # EUROPEAN PATENT APPLICATION
published in accordance with Art. 153(4) EPC

(43) Date of publication:
**11.12.2013 Bulletin 2013/50**

(21) Application number: **11852737.3**

(22) Date of filing: **22.12.2011**

(51) Int Cl.:
***C09J 175/04*** *(2006.01)* ***C09J 7/02*** *(2006.01)*
***H01L 31/042*** *(2006.01)*

(86) International application number:
**PCT/JP2011/079809**

(87) International publication number:
**WO 2012/090856 (05.07.2012 Gazette 2012/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.12.2010 JP 2010292440**

(71) Applicant: **Henkel AG & Co. KGaA**
**40589 Düsseldorf (DE)**

(72) Inventors:
- **ITO, Shoko**
**Minoo-shi**
**Osaka 562-8586 (JP)**
- **YOSHIDA, Yoshio**
**Minoo-shi**
**Osaka 562-8586 (JP)**
- **MATSUKI, Yuichi**
**Minoo-shi**
**Osaka 562-8586 (JP)**

(54) **ADHESIVE FOR SOLAR CELL BACK SHEET**

(57) An object of the present invention is to provide an adhesive for solar battery backsheet, which has satisfactory initial adhesion to a film at the time of the production of the solar battery backsheet and satisfactory adhesive strength to a film after aging, and is also excellent in long-term weatherability and hydrolysis resistance. Further object is to provide a solar battery backsheet obtainable by using the adhesive, and a solar battery module obtainable by using the backsheet. Disclosed is an adhesive for solar battery backsheet obtainable by the reaction of an acrylic polyol (a1) with an isocyanate compound (a2), in which the acrylic polyol (a1) has a glass transition temperature of 20°C or lower. The adhesive has satisfactory initial adhesion to a film at the time of the production of the solar battery backsheet and satisfactory adhesive strength to a film after aging, and is also excellent in long-term weatherability and hydrolysis resistance. The adhesive for solar battery backsheet, in which the acrylic polyol (a1) has a hydroxyl value of 0.5 to 40 mgKOH/g, is more preferable.

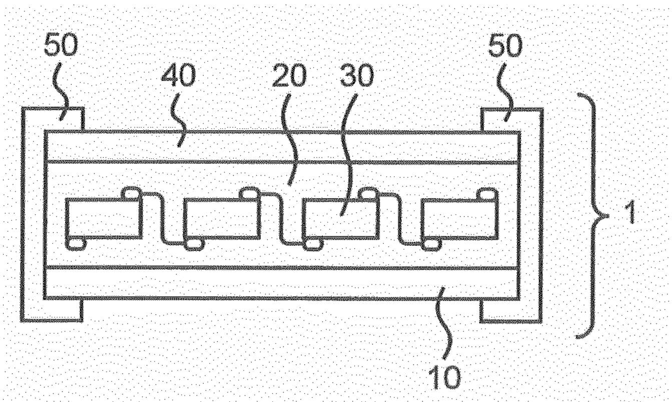


Fig. 3

EP 2 671 930 A1

## Description

### Technical Field

The present invention relates to an adhesive for solar battery backsheet. More particularly, the present invention relates to a solar battery backsheet obtainable by using the adhesive, and a solar battery module obtainable by using the solar battery backsheet.

### Background Art

The practical use of solar batteries as useful energy resources is making progress. The solar batteries include various types; a silicon-based solar battery, an inorganic compound-based solar battery, an organic solar battery and the like are known as typical solar batteries.
In these solar batteries, a surface protective sheet is commonly provided on a surface on which sunlight falls so as to protect the surface. A back side protective sheet (backsheet) is also provided on a surface opposite to the surface on which sunlight falls so as to protect the solar battery cell; it is required for the backsheet to have various physical properties, such as weatherability, water resistance, heat resistance, moisture barrier properties and gas barrier properties, so as to minimize the long-term performance deterioration of the solar battery.
In order to obtain a sheet having these various physical properties, various films are used, and examples thereof include: metal foils, deposited metal films and metal plates such as aluminum, copper and steel plates; plastic films such as polypropylene, polyvinyl chloride, polyester, fluorine resin and acrylic resin films; and the like.
In order to further improve performance, a laminate obtainable by laminating these films is also used as the backsheet of the solar battery.
An example of the laminate obtainable by laminating the films is shown in Fig. 1. A backsheet 10 is a laminate of plural films 11 and 12, and the films 11 and 12 are laminated by interposing an adhesive 13 therebetween.
A lamination method of films is commonly a dry lamination method, and it is required for the adhesive 13 to have sufficient adhesion to the films 11 and 12.
The backsheet 10 constitutes a solar battery module 1, together with a sealing material 20, a solar battery cell 30 and a glass plate 40 (see Fig. 3).
Since the solar battery module 1 is exposed outdoors over a long period, sufficient durability against high temperature, high humidity and sunlight is required. Particularly, when the adhesive 13 has poor performance, the films 11 and 12 are peeled and thus the appearance of the laminated backsheet 10 is diminished. Therefore, it is required that the adhesive for solar battery backsheet does not undergo peeling of the film even if exposed over the long term.
The adhesive for solar battery backsheet can be a urethane adhesive; Patent Documents 1 and 2 disclose the use of urethane-based adhesives in production of a solar battery backsheet.
Patent Document 1 discloses an outdoor urethane-based adhesive in which durability is improved by using a specific polyesterpolyol (see CLAIMS and [0014] etc. of Patent Document 1). Patent Document 1 discloses that an adhesive, which has improved hydrolysis resistance and is effective for solar battery backsheet, is obtained by using a specific polyesterpolyol as an adhesive raw material (see [0070] to [0072] of Patent Document 1).
Patent Document 2 describes an adhesive that is produced by blending an acrylic polyol with an isocyanate curing agent (see Tables 1 and 2 of Patent Document 2); a solar battery backsheet is produced using this adhesive (see [0107] etc. of Patent Document 2).
Patent Documents 1 and 2 disclose that it is possible to prevent a decline in the appearance of a solar battery module by producing a solar battery backsheet using a urethane adhesive. However, the durability required of adhesives for solar battery backsheets increases year by year.
The solar battery backsheet is commonly produced by applying an adhesive to a film, drying the adhesive, laminating films (dry lamination method), and then aging the obtained laminate at about 40 to 60°C for several days. Therefore, it is important that the adhesive for solar battery backsheets has sufficient initial adhesion to a film at the time of lamination and sufficient adhesive strength to a film after aging; it must also be excellent in hydrolysis resistance. However, the adhesives of Patent Documents 1 and 2 do not completely satisfy the above-mentioned performance, necessarily. When the solar battery backsheet is produced by using the adhesives of Patent Documents 1 and 2, plural films constituting the backsheet may be mutually peeled off in a severe outdoor environment.
Furthermore, progress has recently been made in the development of an organic solar battery having lower production costs compared with a solar battery which uses silicon and an inorganic compound material. Since the organic solar battery has a property that it can be colored and also can have flexibility, a transparent film may be employed as the film constituting the solar battery backsheet. Therefore, it is required for the adhesive for solar battery backsheet to maintain the adhesive strength over a long period, to cause little change in color difference even if the adhesive is exposed to ultraviolet rays over a long period, and to have excellent weatherability.

Patent Document 1: JP4416047B
Patent Document 2: JP2010-263193A

Disclosure of the Invention

Problems to be Solved by the Invention

The present invention has been made so as to solve such a problem and an object of the present invention is to provide a urethane adhesive for solar battery backsheets, which has satisfactory initial adhesion to a film at the time of production of said solar battery backsheet and satisfactory adhesive strength to a film after aging, and which is also excellent in long-term weatherability and hydrolysis resistance, a solar battery backsheet obtainable by using the adhesive; and, a solar battery module obtainable by using the solar battery backsheet.

Means for Solving the Problems

The present inventors have intensively studied and found, surprisingly, that it is possible to obtain an adhesive for solar battery backsheets, which has improved initial adhesion to a film at the time of production of a solar battery backsheet and improved adhesive strength to a film after aging, and which is also excellent in long-term weatherability and hydrolysis resistance, by using a specific acrylic polyol as a raw material of a urethane resin, and thus the present invention has been completed.
Namely, the present invention provides, in an aspect, an adhesive for solar battery backsheet including:

a urethane resin obtainable by the reaction of an acrylic polyol (a1) with an isocyanate compound (a2), wherein the acrylic polyol (a1) has a glass transition temperature of 20°C or lower.

The present invention provides, in an embodiment, the above adhesive for solar battery backsheet, wherein the acrylic polyol (a1) has a hydroxyl value of from 0.5 to 40 mgKOH/g.
The present invention provides, in another embodiment, the above adhesive for solar battery backsheet, wherein the acrylic polyol (a1) is obtainable by polymerizing a polymerizable monomer and the polymerizable monomer contains a monomer having a glycidyl group.
The present invention provides, in a preferred embodiment, the above adhesive for solar battery backsheet, which further includes a hydroxyphenyltriazine-based compound.
The present invention provides, in another embodiment, a solar battery backsheet obtainable by using the above defined adhesive.
The present invention provides, in a preferred aspect, a solar battery module obtainable by using the above solar battery backsheet.

Effects of the Invention

Since the adhesive for solar battery backsheet according to the present invention includes a urethane resin obtainable by the reaction of an acrylic polyol (a1) with an isocyanate compound (a2), and the acrylic polyol (a1) has a glass transition temperature of 20°C or lower, initial adhesion to a film and adhesive strength to a film after aging are improved while maintaining excellent weatherability and hydrolysis resistance.
When the acrylic polyol (a1) has a hydroxyl value of from 0.5 to 40 mgKOH/g, an adhesive for solar battery backsheet having further improved adhesive strength to a film after aging is obtained.
Furthermore, with regard to the adhesive for solar battery backsheet according to the present invention, when the acrylic polyol (a1) is obtained by polymerizing a polymerizable monomer and the polymerizable monomer contains a monomer having a glycidyl group, the adhesive strength to a film after aging is further improved, and thus more suitable adhesive is obtained.
When the adhesive for solar battery backsheet according to the present invention further contains a hydroxyphenyltriazine-based compound, the weatherability is remarkably improved, and the adhesive is more preferable.
Since the solar battery backsheet according to the present invention is obtained by using the above adhesive for solar battery backsheet, it is excellent in productivity. Furthermore, even if the backsheet is exposed outdoors over a long period, it is possible to prevent a film from peeling, as a result of degradation of the adhesive, and discoloring.
An organic solar battery using an organic compound in a light absorption layer has recently been developed, and it is required for the organic solar battery to have colorability and flexibility. Therefore, since a film constituting a backsheet

of the organic solar battery may become transparent, the solar battery backsheet according to the present invention which causes little change in color difference is useful from such a point of view.
Since the solar battery module according to the present invention is obtained by using the solar battery backsheet, it is excellent in productivity and is also excellent in appearance and durability.

Brief Description of the Drawings

Fig. 1 is a sectional view showing an embodiment of a solar battery backsheet according to the present invention.
Fig. 2 is a sectional view showing another embodiment of a solar battery backsheet according to the present invention.
Fig. 3 is a sectional view showing an embodiment of a solar battery module according to the present invention.

Mode for Carrying Out the Invention

The adhesive for solar battery backsheets according to the present invention contains a urethane resin (A) obtainable by the reaction of an acrylic polyol (a1) with an isocyanate compound (a2).
The urethane resin (A) according to the present invention is a polymer obtainable by the reaction of an acrylic polyol (a1) with an isocyanate compound (a2), and has a urethane bond.
In the present invention, the "acrylic polyol" refers to a compound obtainable by the addition polymerization reaction of a (meth)acrylate having a hydroxyl group, and has an ester bond on the "side chain".
The "acrylic polyol" may be either a homopolymer of the (meth)acrylate having a hydroxyl group, or a copolymer of the (meth)acrylate having a hydroxyl group with the "other polymerizable monomer", but is preferably the copolymer of the (meth)acrylate having a hydroxyl group with the "other polymerizable monomer" from a viewpoint of adhesive strength or the like. The hydroxyl group of the acrylic polyol reacts with an isocyanate group.
Examples of the "(meth)acrylate having a hydroxyl group" include 2-hydroxyethyl (meth)acrylate, 2-hydroxypropyl (meth)acrylate, 3-hydroxypropyl (meth)acrylate, glycerin mono(meth)acrylate, 4-hydroxybutyl acrylate and the like.
The "other polymerizable monomer" is a "radical polymerizable monomer having an ethylenic double bond" other than the "(meth)acrylate having a hydroxyl group". The other polymerizable monomer preferably contains a polymerizable monomer having a glycidyl group in the present invention. Examples of the "polymerizable monomer having a glycidyl group" include, but are not limited to, glycidyl (meth)acrylate.
In the present invention, the polymerizable monomer for obtaining the acrylic polyol (a1) preferably contains the polymerizable monomer having a glycidyl group in an amount of 0.5 parts by weight or more, and more preferably 0.5 to 10 parts by weight, based on 100 parts by weight of the polymerizable monomer. When the polymerizable monomer having a glycidyl group is contained in the amount of 0.5 parts by weight or more, the adhesive strength to a film after aging can be improved.
Specific examples of the "other polymerizable monomer" include (meth)acrylic acid, methyl (meth)acrylate, ethyl (meth)acrylate, butyl (meth)acrylate, cyclohexyl (meth)acrylate, 2-ethylhexyl (meth)acrylate, dicyclopentanyl (meth) acrylate, glycidyl (meth)acrylate, isobornyl (meth)acrylate, styrene, vinyltoluene and the like.
In the present description, an acrylic acid and a methacrylic acid are collectively referred to as a "(meth)acrylic acid", and an "acrylic acid ester and methacrylic acid ester" are also referred to as a "(meth)acrylate".
The polymerizable monomer containing the (meth)acrylate having a hydroxyl group can generally be polymerized, for example, by radically polymerizing the above polymerizable monomer using a solution polymerization method in an organic solvent in the presence of an appropriate catalyst. Herein, the "organic solvent" can be used so as to polymerize the polymerizable monomer and there is no particular limitation on the organic solvent as long as it does not substantially exert an adverse influence on characteristics as an adhesive for solar battery backsheet after the polymerization reaction. Examples of such a solvent include aromatic-based solvents such as toluene and xylene; alcohol-based solvents such as isopropyl alcohol and n-butyl alcohol; ester-based solvents such as ethyl acetate, butyl acetate; and combinations thereof.
The polymerization reaction conditions such as reaction temperature, reaction time, kind of organic solvents, kind and concentration of monomers, stirring rate, as well as kind and concentration of catalysts in polymerizing the polymerizable monomers can be appropriately selected according to characteristics of the objective adhesive.
The "catalyst" is preferably a compound which can accelerate polymerization of a polymerizable monomer by its addition in a small amount and can be used in an organic solvent. Examples of the catalyst include ammonium persulfate, sodium persulfate, potassium persulfate, t-butyl peroxybenzoate, 2,2-azobisisobutyronitrile (AIBN) and, 2,2-azobis(2-aminodipropane) dihydrochloride. 2,2-Azobis(2,4-dimethylvarelonitrile) and 2,2-azobisisobutyronitrile (AIBN) are particularly preferable.
A chain transfer agent can be appropriately used for the polymerization in the present invention so as to adjust

the molecular weight. It is possible to use, as the "chain transfer agent", compounds well-known to those skilled in the art. Examples thereof include mercaptans such as n-dodecylmercaptan (nDM) and laurylmethylmercaptan.

As mentioned above, the acrylic polyol (a1) can be obtained by polymerizing the polymerizable monomer. From the viewpoint of coatability of the adhesive, the weight average molecular weight of the acrylic polyol (a1) is preferably 200,000 or less, and more preferably from 5,000 to 100,000. The weight average molecular weight is a value measured by gel permeation chromatography (GPC) in terms of polystyrene standard. Specifically, the value can be measured using the following GPC apparatus and measuring method. HCL-8220GPC manufactured by TOSOH CORPORATION is used as a GPC apparatus, and RI is used as a detector. Two TSK gel SuperMultipore HZ-M manufactured by TOSOH CORPORATION are used as a GPC column. A sample is dissolved in tetrahydrofuran and the obtained solution is allowed to flow at a flow rate of 0.35 ml/min and a column temperature of 40°C, and then Mw is determined by conversion of the molecular weight based on a calibration curve which is obtained by using polystyrene having a monodisperse molecular weight as a standard reference material.

A glass transition temperature of the acrylic polyol (a1) can be set by adjusting a mass fraction of a monomer to be used. The glass transition temperature of the acrylic polyol (a1) can be determined based on a glass transition temperature of a homopolymer obtainable from each monomer and a mass fraction of the homopolymer used in the acrylic polyol (a1) using the following calculation formula (i). It is preferred to determine a composition of the monomer using the glass transition temperature determined by the calculation:

$$(i): 1/Tg = W1/Tg1 + W2/Tg2 + \cdots + Wn/Tgn$$

where in the above formula (i), Tg denotes the glass transition temperature of the acrylic polyol (a1), each of W1, W2, ··· ,Wn denotes a mass fraction of each monomer, and each of Tg1, Tg2, ··· , Tgn denotes a glass transition temperature of a homopolymer of each corresponding monomer.

A value described in the document can be used as Tg of the homopolymer. It is possible to refer, as such a document, for example, to the following documents: acrylic ester of Mitsubishi Rayon Co., Ltd. (1997 Version); edited by Kyozo Kitaoka, "Shin Kobunshi Bunko 7, Guide to Synthetic Resin for Coating Material", Kobunshi Kankokai, published in 1997, pp.168-169; and "POLYMER HANDBOOK", 3rd Edition, pp.209-277, John Wiley & Sons, Inc. published in 1989. In the present specification, glass transition temperatures of homopolymers of the following monomers are as follows.

methyl methacrylate: 105°C
n-butyl acrylate: -54°C
2-hydroxyethyl methacrylate: 55°C
cyclohexyl methacrylate: 83°C
n-butyl methacrylate: 20°C
glycidyl methacrylate: 41°C
2-ethylhexyl acrylate: -70°C

In the present invention, the glass transition temperature of the acrylic polyol (a1) is preferably 20°C or lower, more preferably -55°C to 10°C, and particularly preferably from -40°C to -10°C, from the viewpoint of adhesion to a film at the time of lamination.

A hydroxyl value of the acrylic polyol (a1) is preferably from 0.5 to 40 mgKOH/g, more preferably from 1 to 35 mgKOH/g, and particularly preferably from 3 to 30 mgKOH/g. When the hydroxyl value of the acrylic polyol (a1) is 40 mgKOH/g or more, adhesion and adhesiveness to a film may become insufficient. When the hydroxyl value is less than 0.5 mgKOH/g, curing of the urethane resin may become insufficient and hydrolyzability may become insufficient.

In the present description, the hydroxyl value is a number of mg of potassium hydroxide required to neutralize acetic acid combined with hydroxyl groups in case of acetylating 1 g of a resin.

In the present invention, the hydroxyl value is specifically calculated by the following formula (ii).

(ii): Hydroxyl value = [(weight of (meth)acrylate having a hydroxyl group)/(molecular weight of (meth)acrylate having a hydroxyl group)] × (number of mols of hydroxyl groups contained in 1 mol of (meth)acrylate monomer having a hydroxyl group) × [(formula weight of KOH × 1,000)/(weight of the acrylic polyol (a1))]

Examples of the isocyanate compound (a2) include an aliphatic isocyanate, an alicyclic isocyanate and an aromatic isocyanate, and there is no particular limitation on the isocyanate compound as long as the objective adhesive for solar battery backsheet of the present invention can be obtained.

In the present specification, the "aliphatic isocyanate" refers to a compound which has a chain-like hydrocarbon chain in which isocyanate groups are directly combined to the hydrocarbon chain, and also has no cyclic hydrocarbon chain. Although the "aliphatic isocyanate" may have an aromatic ring, the aromatic ring is not directly combined with isocyanate groups.

In the present specification, the aromatic ring is not contained in the cyclic hydrocarbon chain.

The "alicyclic isocyanate" is a compound which has a cyclic hydrocarbon chain and may have a chain-like hydrocarbon chain. The isocyanate group may be either directly combined with the cyclic hydrocarbon chain, or may be directly combined with the obtainable chain-like hydrocarbon chain. Although the "alicyclic isocyanate" may have an aromatic ring, the aromatic ring is not directly combined to isocyanate groups.

The "aromatic isocyanate" refers to a compound which has an aromatic ring, in which isocyanate groups are directly bonded to the aromatic ring. Therefore, a compound, in which isocyanate groups are not directly bound to the aromatic ring is classified into the aliphatic isocyanate or the alicyclic isocyanate even if it contains the aromatic ring in the molecule.

Therefore, for example, 4,4'-diphenylmethane diisocyanate ($OCN-C_6H_4-CH_2-C_6H_4-NCO$) corresponds to the aromatic isocyanate, since the isocyanate groups are directly bound to the aromatic ring. On the other hand, for example, xylylene diisocyanate ($OCN-CH_2-C_6H_4-CH_2-NCO$) corresponds to the aliphatic isocyanate since it has an aromatic ring, but the isocyanate groups are not directly bound to the aromatic ring and combined with methylene groups.

The aromatic ring may be fused with two or more benzene rings.

Examples of the aliphatic isocyanate include 1,4-diisocyanatobutane, 1,5-diisocyanatopentane, 1,6-diisocyanatohexane (hereinafter also referred to as HDI), 1,6-diisocyanato-2,2,4-trimethylhexane, 2,6-diisocyanatohexanoic acid methyl ester (lysine diisocyanate), 1,3-bis(isocyanatomethyl)benzene (xylylene diisocyanate) and the like.

Examples of the alicyclic isocyanate include 5-isocyanato-1-isocyanatomethyl-1,3,3-trimethylcyclohexane (isophorone diisocyanate), 1,3-bis(isocyanatomethyl)cyclohexane (hydrogenated xylylene diisocyanate), bis(4-isocyanatocyclohexyl)methane (hydrogenated diphenylmethane diisocyanate), 1,4-diisocyanatocyclohexane and the like.

Examples of the aromatic isocyanate include, 4,4'-diphenylmethane diisocyanate, p-phenylene diisocyanate, m-phenylene diisocyanate and the like. These isocyanate compounds can be used alone, or in combination.

In the present invention, there is no particular limitation on the isocyanate compound (a2) as long as the objective urethane adhesive according to the present invention can be obtained. From the viewpoint of weatherability, it is preferred to select from the aliphatic isocyanate and the alicyclic isocyanate. Particularly, HDI, isophorone diisocyanate and xylylene diisocyanate are preferable, and a trimer of HDI is particularly preferable.

The urethane resin according to the present invention can be obtained by reacting the acrylic polyol (a1) with the isocyanate compound (a2). In the reaction, a known method can be used and the reaction can be usually performed by mixing the acrylic polyol (a1) with the isocyanate compound (a2). There is no particular limitation on the mixing method as long as the urethane resin according to the present invention can be obtained.

In the present description, a "hydroxyphenyltriazine-based compound (B)" is a compound which is a kind of a triazine derivative in which a hydroxyphenyl derivative is combined with carbon atoms of a triazine derivative, and which is commonly referred to a hydroxyphenyltriazine-based compound. There is no particular limitation on the hydroxyphenyltriazine-based compound as long as the objective adhesive for solar battery backsheet according to the present invention can be obtained.

Examples of such a hydroxyphenyltriazine-based compound (B) include, but are no limited to, compounds represented by the following formulas (1) to (5), and isomers thereof.

[Chemical Formula 1]

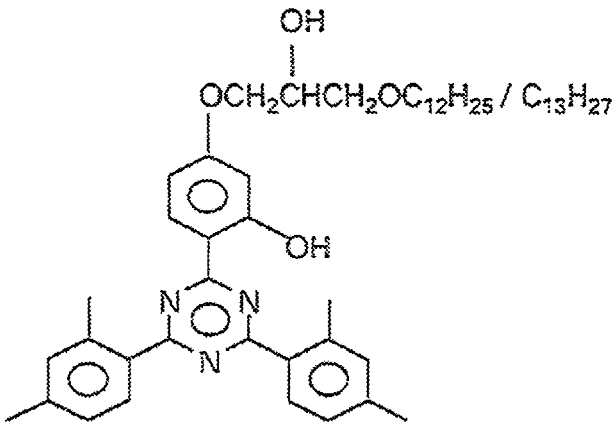

(1)

[Chemical Formula 2]

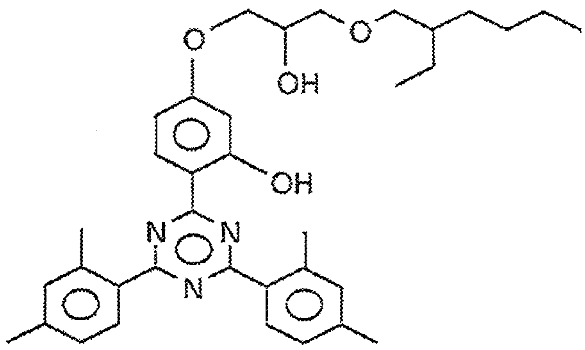

(2)

[Chemical Formula 3]

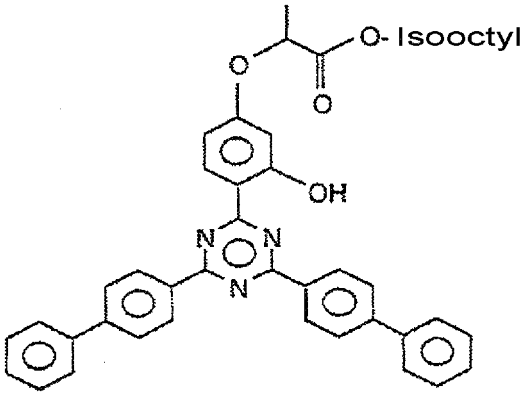

(3)

[Chemical Formula 4]

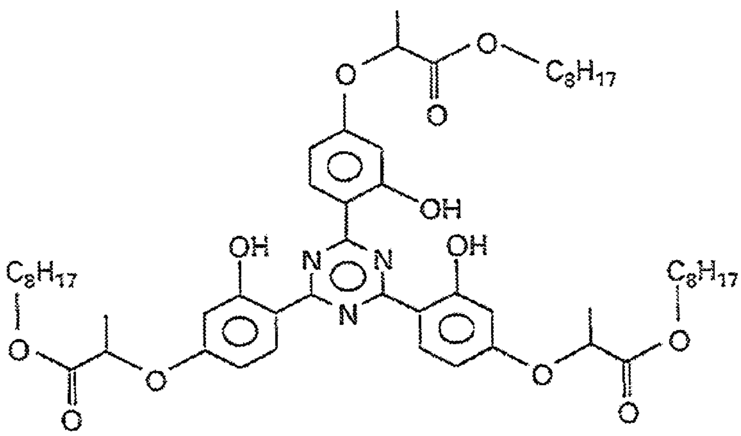

(4)

[Chemical Formula 5]

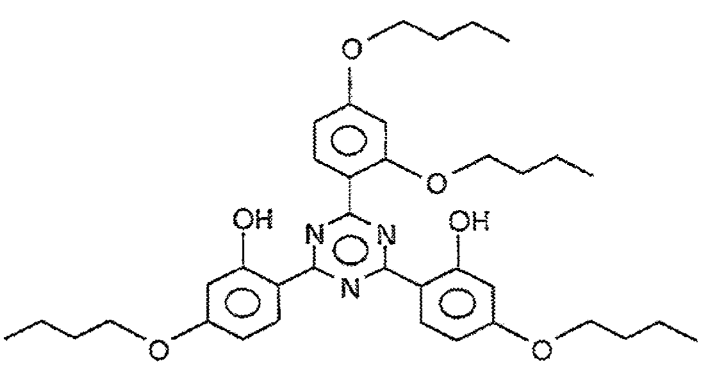

(5)

In the present invention, the hydroxyphenyltriazine-based compound (B) represented by the chemical formula (3) is preferable.
The hydroxyphenyltriazine-based compounds (B) of the chemical formulas (1) to (5) are commonly used as an ultraviolet absorber and can be used in combination with others as long as the objective adhesive for solar battery backsheets according to the present invention can be obtained. Commercially available products can be used as the hydroxyphenyltriazine-based compound (B). Examples thereof include TINUVIN 400, TINUVIN 405, TINUVIN 479, TINUVIN 477 and TINUVIN 460 (all of which are trade names) which are available from BASF Corp.

It is preferred that the adhesive for solar battery backsheets according to the present invention further contains a hindered phenol-based compound. The "hindered phenol-based compound" is commonly referred to as a hindered phenol-based compound, and there is no particular limitation as long as the objective adhesive for solar battery backsheets according to the present invention can be obtained.

Commercially available products can be used as the hindered phenol-based compound. The hindered phenol-based compound is, for example, commercially available from BASF Corp. Examples thereof include IRGANOX1010, IRGANOX1035, IRGANOX1076, IRGANOX1135, IRGANOX1330 and IRGANOX1520 (all of which are trade names). The hindered phenol-based compound is added to the adhesive as an antioxidant and may be used, for example, in combination with a phosphite-based antioxidant, a thioether-based antioxidant, an amine-based antioxidant and the like.

The adhesive for solar battery backsheets according to the present invention may further contain a hindered amine-based compound.
The "hindered amine-based compound" is commonly referred to as a hindered amine-based compound, and there is no particular limitation as long as the objective adhesive for solar battery backsheet according to the present invention can be obtained.

Commercially available products can be used as the hindered amine-based compound. Examples of the hindered amine-based compound include TINUVIN 765, TINUVIN 111FDL, TINUVIN 123, TINUVIN 144, TINUVIN 152, TINUVIN 292 and TINUVIN 5100 (all of which are trade names) which are commercially available from BASF Corp. The hindered amine-based compound is added to the adhesive as a light stabilizer and may be used, for example, in combination with a benzotriazole-based compound, a benzoate-based compound and the like.

The adhesive for solar battery backsheets according to the present invention may further contain a silane compound.
It is possible to use, as the silane compound, for example, (meth)acryloxyalkyltrialkoxysilanes, (meth)acryloxyalkylalkylalkoxysilanes, vinyltrialkoxysilanes, vinylalkylalkoxysilanes, epoxysilanes, mercaptosilanes and isocyanuratesilanes. However, the silane compound is not limited only to these silane compounds.

Examples of the "(meth)acryloxyalkyltrialkoxysilanes" include 3-(meth)acryloxypropyltrimethoxysilane, 3-(meth)acryloxypropyltriethoxysilane, 4-(meth)acryloxyethyltrimethoxysilane and the like.
Examples of the "(meth)acryloxyalkylalkylalkoxysilanes" include 3-(meth)acryloxypropylmethyldimethoxysilane, 3-(meth)acryloxypropylmethyldiethoxysilane, 3-(meth)acryloxypropylethyldiethoxysilane, 3-(meth)acryloxyethylmethyldimethoxysilane and the like.

Examples of the "vinyltrialkoxysilanes" include vinyltrimethoxysilane, vinyltriethoxysilane, vinyldimethoxyethoxysilane, vinyltri(methoxyethoxy)silane, vinyltri(ethoxymethoxy)silane and the like.
Examples of the "vinylalkylalkoxysilanes" include vinylmethyldimethoxysilane,
vinylethyldi(methoxyethoxy)silane,
vinyldimethylmethoxysilane,
vinyldiethyl(methoxyethoxy)silane and the like.

For example, the "epoxysilanes" can be classified into glycidyl-based silanes and epoxycyclohexyl-based silanes. The "glycidyl-based silanes" have a glycidoxy group, and specific examples thereof include 3-glycidoxypropylmethyldiisopropenoxysilane, 3-glycidoxypropyltrimethoxysilane, 3-glycidoxypropyltriethoxysilane, 3-glycidoxypropyldiethoxysilane and the like.
The "epoxycyclohexyl-based silanes" have a 3,4-epoxycyclohexyl group, and specific examples thereof include 2-(3,4-epoxycyclohexyl)ethyltrimethoxysilane, 2-(3,4-epoxycyclohexyl)ethyltriethoxysilane and the like.

Examples of the "mercaptosilanes" include 3-mercaptopropyltrimethoxysilane, 3-mercaptopropyltriethoxysilane and the like.
Examples of the "isocyanuratesilanes" include tris(3-(trimethoxysilyl)propyl)isocyanurate and the like.

The adhesive for solar battery backsheet according to the present invention can further contain the other components as long as the objective adhesive for solar battery backsheets can be obtained.
There is no particular limitation on timing of the addition of the "other components" to the adhesive as long as the objective adhesive for solar battery backsheets according to the present invention can be obtained. For example, the other components may be added, together with the acrylic polyol (a1) and the isocyanate compound (a2), in synthesizing the urethane resin, or may be added together on adding the hydroxyphenyltriazine-based compound (B) after synthesizing the urethane resin by reacting the acrylic polyol (a1) with the isocyanate compound (a2).

Examples of the "other components" include a tackifier resin, a pigment, a plasticizer, a flame retardant, a catalyst, a wax and the like.
Examples of the "tackifier resin" include a styrene-based resin, a terpene-based resin, aliphatic petroleum resin, an aromatic petroleum resin, a rosin ester, an acrylic resin, a polyester resin (excluding polyesterpolyol) and the like.
Examples of the "pigment" include titanium oxide, carbon black and the like.
Examples of the "plasticizer" include dioctyl phthalate, dibutyl phthalate, diisononyl adipate, dioctyl adipate, mineral spirit and the like.
Examples of the "flame retardant" include a halogen-based flame retardant, a phosphorous-based flame retardant, an antimony-based flame retardant and, metal hydroxide-based flame retardant and the like.
Examples of the "catalyst" include metal catalysts such as tin catalysts (trimethyltin laurate, trimethyltin hydroxide, dibutyltin dilaurate, dibutyltin maleate, etc.), lead-based catalysts (lead oleate, lead naphthenate, lead octenoate, etc.), and other metal catalysts (naphthenic acid metal salts such as cobalt naphthenate) and amine-based catalysts such as triethylenediamine, tetramethylethylenediamine, tetramethylhexylenediamine, diazabicycloalkenes, dialkylaminoalkylamines and the like.
The "wax" is preferably a wax such as paraffin wax and microcrystalline wax.
The urethane adhesive for solar battery backsheet according to the present invention can be produced by mixing the above-mentioned urethane resin and the hydroxyphenyltriazine-based compound (B), and the other components which are optionally added. There is no particular limitation on the mixing method as long as the objective urethane adhesive for solar battery backsheet according to the present invention can be obtained. There is also no particular limitation on the order of mixing the components. The urethane adhesive for solar battery backsheet according to the present invention can be produced without requiring a special mixing method and a special mixing order. The obtained urethane adhesive for solar battery backsheet is excellent in productivity and adhesive strength to a backsheet film, and is also excellent in weatherability and hydrolysis resistance.
It is required for an adhesive for producing a solar battery module to have excellent productivity, and strength and weatherability in high level. The urethane adhesive for solar battery backsheets according to the present invention is excellent in suitability for lamination to a film and adhesive strength to a film and is also excellent in weatherability and hydrolysis resistance, and thus the urethane adhesive is suitable as an adhesive for a solar battery backsheet.
In case of producing a solar battery backsheet, the adhesive according to the present invention is applied to a film. Application can be performed by various methods such as gravure coating, wire bar coating, air knife coating, die coating, lip coating and comma coating methods. Plural films coated with the urethane adhesive according to the present invention are laminated with each other to obtain the solar battery backsheet.
Embodiments of the solar battery backsheet according to the present invention are shown in Figs. 1 to 3, but the present invention is not limited to these embodiments.
Fig. 1 is a sectional view of a solar battery backsheet according to the present invention. The solar battery backsheet 10 is formed of two films and an adhesive for solar battery backsheet 13 interposed therebetween, and the two films 11 and 12 are laminated with each other by the adhesive for solar battery backsheet 13. The films 11 and 12 may be made of either the same or different material. In Fig. 1, the two films 11 and 12 are laminated with each other, or three or more films may be laminated with one another.
Another embodiment of the solar battery backsheet according to the present invention is shown in Fig. 2. In Fig. 2, a thin film 11a is formed between the film 11 and the adhesive for solar battery backsheet 13. For example, the drawing shows an embodiment in which a metal thin film 11a is formed on the surface of the film 11 when the film 11 is a plastic film. The metal thin film 11a can be formed on the surface of the plastic film 11 by vapor deposition, and the solar battery backsheet of Fig. 2 can be obtained by laminating the film 11 (on which surface the metal thin film 11a formed) with the film 12 by interposing the adhesive for solar battery backsheet 13 therebetween.
Examples of the metal to be deposited on the plastic film include aluminum, steel, copper and the like. It is possible to impart barrier properties to the plastic film by subjecting the film to vapor deposition. Silicon oxide or aluminum oxide is used as a vapor deposition material. The plastic film 11 as a base material may be either transparent, or white- or black-colored.
A plastic film made of polyvinyl chloride, polyester, a fluorine resin or an acrylic resin is used as the film 12. In order to impart heat resistance and weatherability as well as rigidity, insulating properties and the like, a polyethylene terephthalate film or a polybutylene terephthalate film is preferably used. The films 11 and 12 may be either transparent or colored.
The deposited thin film 11a of the film 11 and the film 12 are laminated with each other using the adhesive for solar battery backsheet 13 according to the present invention, and the films 11 and 12 are often laminated with each other by a dry lamination method. Therefore, it is required for the adhesive for solar battery backsheet 13 to have excellent adhesion to a film at the time of lamination and excellent adhesive strength to a film after aging.
Fig. 3 shows a sectional view of an example of a solar battery module according to the present invention. In Fig. 3, it is possible to obtain a solar battery module 1 according to the present invention by laying a glass plate 40, a

sealing material 20 such as an ethylene-vinyl acetate resin (EVA), plural solar battery cells 30 which are commonly connected to each other to generate a desired voltage, and a backsheet 10 over one another, and then fixing these members 10, 20, 30 and 40 using a spacer 50.

As mentioned above, since the backsheet 10 is a laminate of plural films 11 and 12, it is required for the urethane adhesive 13 to cause no peeling of the films 11 and 12 even if the backsheet 10 is exposed outdoors over a long period, and also to have excellent hydrolysis resistance.

The solar battery cell 30 is often produced by using silicon, and is sometimes produced by using an organic resin containing a dye. In that case, the solar battery module 1 becomes an organic-based (dye-sensitization) solar battery module. Since colorability is required of the organic-based (dye-sensitization) solar battery, a transparent film is often used as the films 11 and 12 which constitute the solar battery backsheet 10. Therefore, it is required for the adhesive for solar battery backsheet 13 to cause very little change in color difference even if exposed outdoors over a long period, and to have excellent weatherability.

Main embodiments of the present invention will be shown below.

1. An adhesive for solar battery backsheet including:

   a urethane resin obtainable by the reaction of an acrylic polyol (a1) with an isocyanate compound (a2), wherein the acrylic polyol (a1) has a glass transition temperature of 20°C or lower.

2. The adhesive for solar battery backsheet according to the above 1, wherein the acrylic polyol (a1) has a hydroxyl value of from 0.5 to 40 mgKOH/g.
3. The adhesive for solar battery backsheet according to the above 1 or 2, wherein the acrylic polyol (a1) is obtainable by polymerizing a polymerizable monomer and the polymerizable monomer contains a monomer having a glycidyl group.
4. The adhesive for solar battery backsheet according to any one of the above 1 to 3, wherein the adhesive includes a hydroxyphenyltriazine-based compound.
5. A solar battery backsheet obtainable by using the adhesive for solar battery backsheet according to any one of the above 1 to 4.
6. A solar battery module obtainable by using the solar battery backsheet according to the above 5.

Examples

The present invention will be described below by way of Examples and Comparative Examples; these Examples are merely for illustrative purposes and are not meant to be limiting on the present invention.

<Synthesis of acrylic polyol (a1)>

Synthetic Example 1 (Acrylic polyol (a1-1))

In a four-necked flask equipped with a stirring blade, a thermometer and a reflux condenser tube, 150 g of ethyl acetate (manufactured by Wako Pure Chemical Industries, Ltd.) was charged and refluxed at about 80°C. In the flask, 1 g of 2,2-azobisisobutyronitrile as a polymerization initiator was added and a mixture of monomers in each amount shown in Table 1 was continuously added dropwise over 1 hour and 30 minutes. After heating for 2 hours, a solution of an acrylic polyol (a1-1) having a non-volatile content of 39.8% by weight was obtained.
The composition of the polymerizable monomer component of the acrylic polyol (a1-1) and physical properties of the obtained acrylic polyol (a1-1) are shown in Table 1.

Synthetic Examples 2 to 14

In the same manner as in Synthetic Example 1, except that the composition of monomers used in the synthesis of the acrylic polyol (a1-1) in Synthetic Example 1 was changed as shown in Table 1 and Table 2, acrylic polyols (a1-2) to (a1-12) and acrylic polymers (a1'-13) and (a1'- 14) were obtained. Physical properties of the obtained acrylic polyols are shown in Table 1 and Table 2.
The polymerizable monomers shown in Table 1 and Table 2, and other components thereof are shown below. Methyl methacrylate (MMA): manufactured by Wako Pure Chemical Industries, Ltd.

Butyl acrylate (BA): manufactured by Wako Pure Chemical Industries, Ltd.

Cyclohexyl methacrylate (CHMA): manufactured by Wako Pure Chemical Industries, Ltd.

Butyl methacrylate (BA): manufactured by Wako Pure Chemical Industries, Ltd.

2-ethylhexyl acrylate (2EHA): manufactured by Wako Pure Chemical Industries, Ltd.

Glycidyl methacrylate (GMA): manufactured by Wako Pure Chemical Industries, Ltd.

2-hydroxyethyl methacrylate (HEMA): manufactured by Wako Pure Chemical Industries, Ltd.

2,2-azobisisobutyronitrile (AIBN): manufactured by Otsuka Chemical Co., Ltd.

n-dodecylmercaptan (nDM): manufactured by NOF CORPORATION

Table 1

| | Synthetic Examples | | | | | | |
|---|---|---|---|---|---|---|---|
| | 1 | 2 | 3 | 4 | 5 | 6 | 7 |
| MMA | 3 | 5 | 5 | 5 | 5 | 5 | 10 |
| BA | 0 | 0 | 0 | 0 | 0 | 0 | 62 |
| CHMA | 12 | 34 | 30 | 32 | 30 | 34 | 22 |
| BMA | 0 | 0 | 0 | 0 | 0 | 0 | 0 |
| 2EHA | 81 | 57 | 57 | 57 | 58 | 58 | 0 |
| GMA | 0 | 2 | 2 | 2 | 5 | 2 | 0 |
| HEMA | 4 | 2 | 6 | 4 | 2 | 1 | 6 |
| AIBN | 1 | 1 | 1 | 1 | 0.5 | 0.25 | 1 |
| nDM | 0 | 0 | 0 | 2 | 0 | 0 | 0 |
| Tg(°C) | -52 | -24 | -25 | -25 | -26 | -25 | -16 |
| Hydroxyl value (mgKOH/g) | 17.2 | 8.6 | 25.9 | 17.2 | 8.6 | 4.3 | 25.9 |
| Weight average molecular weight | 42,000 | 41,700 | 41,000 | 9,800 | 72,300 | 101,000 | 49,500 |
| Polymer | (a1-1) | (a1-2) | (a1-3) | (a1-4) | (a1-5) | (a1-6) | (a1-7) |
| | Polymer -1 | Polymer -2 | Polymer -3 | Polymer -4 | Polymer -5 | Polymer -6 | Polymer -7 |

[Table 2]

| | Synthetic Examples | | | | | | |
|---|---|---|---|---|---|---|---|
| | 8 | 9 | 10 | 11 | 12 | 13 | 14 |
| MMA | 10 | 10 | 10 | 3 | 18 | 10 | 11 |
| BA | 62 | 62 | 62 | 0 | 0 | 20 | 66 |
| CHMA | 18 | 20 | 17 | 48 | 42 | 40 | 21 |

(continued)

| | Synthetic Examples | | | | | | |
|---|---|---|---|---|---|---|---|
| | 8 | 9 | 10 | 11 | 12 | 13 | 14 |
| BMA | 0 | 0 | 0 | 0 | 0 | 22 | 0 |
| 2EHA | 0 | 0 | 0 | 45 | 36 | 0 | 0 |
| GMA | 2 | 2 | 5 | 2 | 2 | 2 | 2 |
| HEMA | 8 | 6 | 6 | 2 | 2 | 6 | 0 |
| AIBN | 1 | 1 | 1 | 1 | 1 | 1 | 1 |
| nDM | 0 | 0 | 0 | 0 | 0 | 0 | 0 |
| Tg(°C) | -17 | -17 | -18 | -8 | 8 | 30 | -20 |
| Hydroxyl value (mgKOH/g) | 34.5 | 25.9 | 25.9 | 8.6 | 8.6 | 25.9 | 0 |
| Weight average molecular weight | 41,300 | 52,800 | 52,600 | 42,800 | 41,200 | 37,200 | 41,200 |
| Polymer | (a1-8) | (a1-9) | (a1-10) | (a1-11) | (a1-12) | (a1'-13) | (a1'-14) |
| | Polymer -8 | Polymer -9 | Polymer -10 | Polymer -11 | Polymer -12 | Polymer -13 | Polymer -14 |

<Calculation of glass transition temperature (Tg) of polymer (a1)>

Tgs of the polymers 1 to 14 ((a1) and (a1')) were calculated by the above-mentioned formula (i) using the glass transition temperatures of homopolymers of the "polymerizable monomers" as a raw material of each polymer.
A document value was used as Tg of each homopolymer of methyl methacrylate and the like.

<Production of adhesive for solar battery backsheet>

Raw materials of adhesives for solar battery backsheet used in Examples and Comparative Examples are shown below.

(a1) Acrylic polyol

The acrylic polyols (a1-1) to (a1-12) correspond to the polymers 1 to 12 shown in Tables 1 and 2.

(a1') Polymer

The acrylic polyol (a1'-13) corresponds to the polymer 13 shown in Table 2.
The acrylic polyol (a1'-14) corresponds to the polymer 14 shown in Table 2.
A polyesterpolyol (a1'-15) is a polyesterpolyol obtained from phthalic anhydride and 2,4-dibutyl-1,5-pentanediol manufactured by HOKOKU Co., Ltd. under the trade name of HS 2N-226P.

(a2) Isocyanate compound

(a2-1) SUMIDULE N3300 (trade name) manufactured by Sumika Bayer Urethane Co., Ltd.: Aliphatic isocyanate (1,6-diisocyanatohexane (HDI))

A urethane resin (A) is obtained by reacting a component (a1) with a component (a2).

(B) Hydroxyphenyltriazine-based compound

(b-1) TINUVIN 479 (trade name) manufactured by BASF Corp.: 2-[4-(octyl-2-methylethanoate)oxy-2-hydroxyphenyl]-4,6-[bis(2,4-dimethylphenyl)]-1,3,5-triazine

(B') Benzotriazole-based compound

(b'-1) TINUVIN 328 (trade name) manufactured by BASF Corp.: 2-(3,5-di-tert-amyl-2-hydroxyphenyl)benzotriazole)

Hindered phenol-based compound
IRGANOX 1330 (trade name) manufactured by BASF Corp.: 1,3,5-trimethyl-2,4,6-tris(3,5-di-t-butyl-4-hydroxybenzyl) benzene
The below-mentioned adhesives for solar battery backsheet of Examples 1 to 14 and the adhesives of Comparative Examples 1 to 4 were produced using the above-mentioned components, and performances of the obtained adhesives for solar battery backsheet were evaluated. Production methods and evaluation methods are shown below.

Example 1

<Production of adhesive for solar battery backsheet>

As shown in Table 3,
90.7 g of the polymer 1 (a1-1) [228 g of the ethyl acetate solution of the polymer 1 (solid content: 39.8% by weight)],
9.3 g of SUMIDULE N3300 (trade name) (a2-1) manufactured by Sumika Bayer Urethane Co., Ltd.,
0.5 g of TINUVIN 479 (trade name) (b-1) manufactured by BASF Corp., and
0.2 g of IRGANOX 1330 (trade name) manufactured by BASF Corp. were weighed and then mixed to prepare an adhesive solution. Using this solution thus prepared as an adhesive for solar battery backsheet, the following tests were carried out.

<Production of adhesive-coated PET sheet 1 and film laminate 2>

First, the adhesive for solar battery backsheet of Example 1 was applied to a transparent polyethylene terephthalate (PET) sheet (manufactured by Mitsubishi Polyester Film Corporation under the trade name of O300EW36) so that the weight of the solid component becomes 10 g/$m^2$, and then dried at 80°C for 10 minutes to obtain an adhesive-coated PET sheet 1.
Then, a surface-treated transparent polyolefin film (linear low-density polyethylene film manufactured by Futamura Chemical Co., Ltd. under the trade name of LL-XUMN #30) was laid on the adhesive-coated surface of the adhesive-coated PET sheet 1 so that the surface-treated surface is brought into contact with the adhesive-coated surface, and then both films were pressed using a planar press machine (manufactured by SHINTO Metal Industries Corporation under the trade name of ASF-5) under a pressing pressure of 1.0 MPa at 50°C for 30 minutes. While pressing, both films were aged at 50°C for one week to obtain a film laminate 2.

<Evaluation>

The adhesive for solar battery backsheet was evaluated by the following method.

1. Evaluation of initial adhesion to film

Under a room temperature environment, the adhesive-coated sheet 1 was cut out into pieces of 15 mm in width, and a surface-treated surface of a surface-treated transparent polyolefin film (linear low-density polyethylene film, manufactured by Futamura Chemical Co., Ltd. under the trade name of LL-XUMN #30) was laid on the adhesive-coated surface of the adhesive-coated sheet 1, and then both films are laminated each other by pressing using a 2 kg roller in a single reciprocal motion. Using a tensile strength testing machine (manufactured by ORIENTEC Co., Ltd. under the trade name of TENSILON RTM-250), a 180° peel test was carried out under a room temperature environment at a testing speed of 100 mm/min. The evaluation criteria are as shown below.

A: Peel strength is 1 N/15 mm or more
B: Peel strength is 0.1 N/15 mm or more but less than 1 N/15 mm
D: Peel strength is less than 0.1 N/15 mm

2. Measurement of peel strength to film after aging

A film laminate 2 was cut into pieces of 15 mm in width, and then a 180° peel test was carried out under a room temperature environment at a testing speed of 100 mm/min, using a tensile strength testing machine (manufactured by ORIENTEC Co., Ltd. under the trade name of TENSILON RTM-250. The evaluation criteria are as shown below

A: Peel strength is 8N/15 mm or more
B: Peel strength is 6N/15 mm or more but less than 8N/15 mm
D: Peel strength is less than 6N/15 mm

3. Evaluation of hydrolysis resistance

The evaluation was carried out by an accelerated evaluation method using pressurized steam. A film laminate 2 was cut into pieces of 15 mm in width, left to stand under a pressurizing environment at 120°C under 0.1 MPa for 100 hours using a high-pressure cooker (manufactured by Yamato Scientific Co., Ltd. under the trade name of Autoclave SP300, and then aged under a room temperature environment for one day. Floating (or Lifting) and peeling of the polyolefin film and PET film of the sample were visually observed. The evaluation criteria are as follows.

A: Neither lifting nor peeling of film was observed.
D: Both lifting and peeling of film were observed.

4. Evaluation of yellowing due to UV irradiation

A film laminate 2 was set to a UV irradiation tester (manufactured by IWASAKI ELECTRIC CO., LTD. under the trade name of EYE Super UV Tester W13) so that a polyolefin film side corresponds to a surface to be irradiated, and then irradiation was carried out under the conditions of an illuminance of 1,000 W/m$^2$ at 60°C and 50%RH for 15 hours. Using a color difference meter, a color difference ($\Delta$b) before and after irradiation was measured and the degree of yellowness was evaluated. Evaluation criteria are as follows.

A: $\Delta$b is less than 8.
B: $\Delta$b is 8 or more and less than 10.
C: $\Delta$b is 10 or more and less than 15.
D: $\Delta$b is 15 or more.

Examples 2 to 14 and Comparative Examples 1 to 4

In the same manner as in Example 1, adhesives for solar battery backsheet were produced according to the compositions shown in Tables 3 to 5.

Table 3

| | | Examples | | | | | | |
|---|---|---|---|---|---|---|---|---|
| | | 1 | 2 | 3 | 4 | 5 | 6 | 7 |
| (a1) | (a1-1) | 90.7 | | | | | | |
| | (a1-2) | | 95.1 | 90.7 | | | | |
| | (a1-3) | | | | 86.6 | | | |
| | (a1-4) | | | | | 90.7 | | |
| | (a1-5) | | | | | | 95.1 | |
| | (a1-6) | | | | | | | 97.6 |
| | (a1-7) | | | | | | | |
| | (a1-8) | | | | | | | |
| | (a1-9) | | | | | | | |
| | (a1-10) | | | | | | | |
| | (a1-11) | | | | | | | |
| | (a1-12) | | | | | | | |
| (a1') | (a1'-13) | | | | | | | |
| | (a1'-14) | | | | | | | |
| | (a1'-15) | | | | | | | |
| (a2) | (a2-1) | 9.3 | 4.9 | 9.3 | 13.4 | 9.3 | 4.9 | 2.4 |
| (B) | (b-1) | 0.5 | 0.5 | 0.5 | 0.5 | 0.5 | 0.5 | 0.5 |
| (B') | (b'-1) | | | | | | | |
| Hindered phenol | | 0.2 | 0.2 | 0.2 | 0.2 | 0.2 | 0.2 | 0.2 |
| Initial adhesion to film | | A | A | A | A | A | A | A |
| Peel strength (N/15 mm) | | B | A | A | B | B | A | B |
| Hydrolysis resistance | | A | A | A | A | A | A | A |
| Δb after irradiation with UV for 15 hours | | A | A | A | A | B | A | A |

Table 4

| | | Examples | | | | | | |
|---|---|---|---|---|---|---|---|---|
| | | 8 | 9 | 10 | 11 | 12 | 13 | 14 |
| (a1) | (a1-1) | | | | | | | |
| | (a1-2) | | | | | | | |
| | (a1-3) | | | | | | | |
| | (a1-4) | | | | | | | |
| | (a1-5) | | | | | | | |
| | (a1-6) | | | | | | | |
| | (a1-7) | 86.6 | | | | | | |
| | (a1-8) | | 83 | | | | | |
| | (a1-9) | | | 86.6 | 86.6 | | | |
| | (a1-10) | | | | | 86.6 | | |
| | (a1-11) | | | | | | 95.1 | |
| | (a1-12) | | | | | | | 95.1 |
| (a1') | (a1'-13) | | | | | | | |
| | (a1'-14) | | | | | | | |
| | (a1'-15) | | | | | | | |
| (a2) | (a2-1) | 13.4 | 17 | 13.4 | 13.4 | 13.4 | 4.9 | 4.9 |
| (B) | (b-1) | 0.5 | 0.5 | 0.5 | | 0.5 | 0.5 | 0.5 |
| (B') | (b'-1) | | | | 0.5 | | | |
| Hindered phenol | | 0.2 | 0.2 | 0.2 | 0.2 | 0.2 | 0.2 | 0.2 |
| Initial adhesion to film | | A | A | A | A | A | A | B |
| Peel strength (N/15 mm) | | B | B | A | A | A | A | B |
| Hydrolysis resistance | | A | A | A | A | A | A | A |
| Δb after irradiation with UV for 15 hours | | A | A | A | B | A | A | A |

Table 5

| | | Comparative Examples | | | |
|---|---|---|---|---|---|
| | | 1 | 2 | 3 | 4 |
| (a1) | (a1-1) | | | | |
| | (a1-2) | | | | |
| | (a1-3) | | | | |
| | (a1-4) | | | | |
| | (a1-5) | | | | |
| | (a1-6) | | | | |
| | (a1-7) | | | | |
| | (a1-8) | | | | |
| | (a1-9) | | | | |
| | (a1-10) | | | | |
| | (a1-11) | | | | |
| | (a1-12) | | | | |
| (a1') | (a1'-13) | 86.6 | | | |
| | (a1'-14) | | 90.7 | | |
| | (a1'-15) | | | 86.8 | 86.5 |
| (a2) | (a2-1) | 13.4 | 9.3 | 13.2 | 13.5 |
| (B) | (b-1) | 0.5 | 0.5 | 0.5 | |
| (B') | (b'-1) | | | | 0.5 |
| Hindered phenol | | 0.2 | 0.2 | 0.2 | 0.2 |
| Initial adhesion to film | | D | A | A | A |
| Peel strength (N/15 mm) | | D | D | A | A |
| Hydrolysis resistance | | A | D | D | D |
| Δb after irradiation with UV for 15 hours | | A | A | C | D |

As shown in Tables 1 to 4, since the adhesives for solar battery backsheet of Examples 1 to 14 contain a urethane resin obtainable by the reaction of an acrylic polyol (a1) with an isocyanate compound (a2) and the acrylic polyol (a1) has a glass transition temperature of 20°C or lower, the adhesives are excellent in initial adhesion to a film and adhesive strength (peel strength) after aging and are also excellent in hydrolysis resistance and weatherability, and thus they are generally well-balanced adhesives. Therefore, the adhesives of the Examples are suited for use as an adhesive for solar battery backsheet.

Particularly, the adhesives for solar battery backsheet of Examples 2, 3, 6, 10, 12 and 13 are excellent in all of initial adhesion to a film, adhesive (peel) strength to a film after aging, hydrolysis resistance and weatherability, and thus they are more suited for use as an adhesive for backsheet of an organic-based (dye-sensitization) solar battery.

To the contrary, the adhesive of Comparative Example 1 is inferior in adhesion to a film and peel strength since the acrylic polyol (a'1-13) had a glass transition temperature of higher than 20°C.

The adhesive of Comparative Example 2 is inferior in peel strength and hydrolysis resistance since it is an adhesive using the polymer (a1'-14) composed only of the other polymerizable monomer in place of the acrylic polyol (a1).

The adhesives of Comparative Examples 3 and 4 are inferior in hydrolysis resistance and weatherability since they are adhesives using the polyesterpolyol (a1'-15) in place of the acrylic polyol (a1). Furthermore, the adhesive of Comparative Example 4 is drastically inferior in weatherability since it does not contain hydroxyphenyltriazine (b-1).

As is apparent from these results, adhesives which contain a urethane resin obtainable by the reaction of an acrylic polyol (a1) with an isocyanate compound (a2) wherein the glass transition temperature of the acrylic polyol (a1) is 20°C or lower, are excellent for solar battery backsheets.

Industrial Applicability

The present invention provides an adhesive for solar battery backsheets. The adhesive for solar battery backsheets according to the present invention has productivity, adhesion to a film and long-term weatherability, and durability, and can be suitably used in a solar battery backsheet and a solar battery module.

Related Application

This application claims priority under Article 4 of the Paris Convention on Japanese Patent Application No. 2010-292440 filed on December 28, 2010, the disclosure of which is incorporated by reference herein.

Description of Reference Numerals

| | |
|---|---|
| 1: | Solar battery module |
| 10: | Backsheet |
| 11: | Film |
| 11a: | Deposited thin film |
| 12: | Film |
| 13: | Adhesive layer |
| 20: | Sealing material (EVA) |
| 30: | Solar battery cell |
| 40: | Glass plate |
| 50: | Spacer |

## Claims

**1.** An adhesive for solar battery backsheet comprising:

a urethane resin obtainable by the reaction of an acrylic polyol (a1) with an isocyanate compound (a2), wherein the acrylic polyol (a1) has a glass transition temperature of 20°C or lower.

**2.** The adhesive for solar battery backsheet according to claim 1, wherein the acrylic polyol (a1) has a hydroxyl value of from 0.5 to 40 mgKOH/g.

**3.** The adhesive for solar battery backsheet according to claim 1 or 2, wherein the adhesive further comprises a hydroxyphenyltriazine-based compound.

**4.** A solar battery backsheet obtainable by using the adhesive for solar battery backsheet according to any one of claims 1-3.

**5.** A solar battery module obtainable by using the solar battery backsheet according to claim 4.

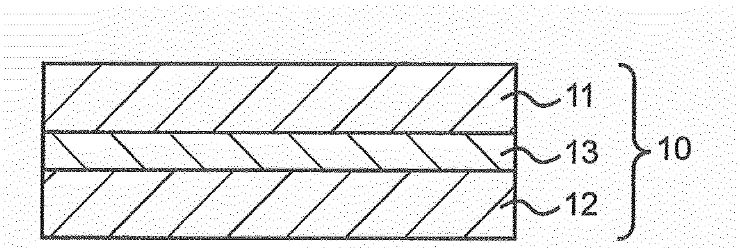


Fig. 1

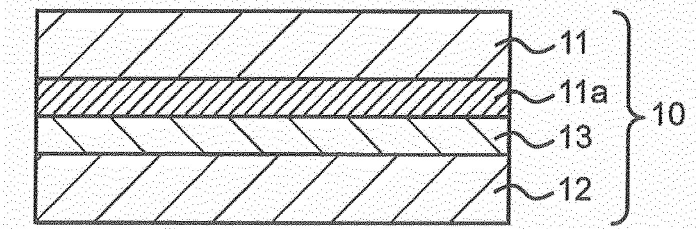


Fig. 2

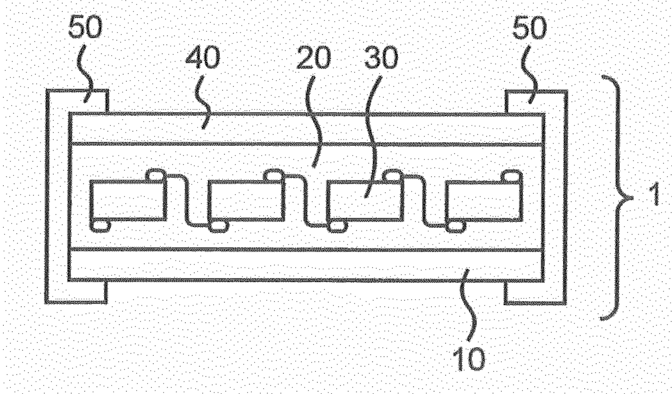


Fig. 3

**INTERNATIONAL SEARCH REPORT**

International application No. PCT/JP2011/079809

A. CLASSIFICATION OF SUBJECT MATTER
*C09J175/04*(2006.01)i, *C09J7/02*(2006.01)i, *H01L31/042*(2006.01)i

According to International Patent Classification (IPC) or to both national classification and IPC

B. FIELDS SEARCHED

Minimum documentation searched (classification system followed by classification symbols)
C09J175/04, C09J7/02, H01L31/042

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2009-246360 A (Nippon Shokubai Co., Ltd.), 22 October 2009 (22.10.2009), claims 1, 4 to 5, 10; paragraph [0068] & WO 2009/113318 A1 | 1-5 |
| Y | JP 2010-263193 A (Nippon Shokubai Co., Ltd.), 18 November 2010 (18.11.2010), claims 1 to 4; paragraph [0053] (Family: none) | 1-5 |
| Y | JP 8-253749 A (Nippon Carbide Industries Co., Inc.), 01 October 1996 (01.10.1996), claims 7 to 8; paragraph [0019] (Family: none) | 1-5 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>27 March, 2012 (27.03.12) | Date of mailing of the international search report<br>10 April, 2012 (10.04.12) |
| Name and mailing address of the ISA/<br>Japanese Patent Office<br>Facsimile No. | Authorized officer<br><br>Telephone No. |

Form PCT/ISA/210 (second sheet) (July 2009)

**INTERNATIONAL SEARCH REPORT**

International application No.
PCT/JP2011/079809

C (Continuation). DOCUMENTS CONSIDERED TO BE RELEVANT

| Category* | Citation of document, with indication, where appropriate, of the relevant passages | Relevant to claim No. |
|---|---|---|
| P,X | JP 2011-105819 A (Toyo Ink Manufacturing Co., Ltd.), 02 June 2011 (02.06.2011), claim 1; paragraph [0048] (Family: none) | 1-5 |
| P,X | JP 2011-111519 A (Toyo Ink SC Holdings Co., Ltd.), 09 June 2011 (09.06.2011), claim 1; paragraphs [0058], [0110] (Family: none) | 1-5 |
| E,X | WO 2012/004961 A1 (Toyo Ink SC Holdings Co., Ltd.), 12 January 2012 (12.01.2012), example 7; table 2 (Family: none) | 1-5 |
| E,X | WO 2012/004962 A1 (Toyo Ink SC Holdings Co., Ltd.), 12 January 2012 (12.01.2012), example 9; table 2 (Family: none) | 1-5 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 4416047 B
- JP 2010263193 A
- JP 2010292440 A


### Non-patent literature cited in the description


- **KOBUNSHI KANKOKAI.** Shin Kobunshi Bunko 7, Guide to Synthetic Resin for Coating Material. Mitsubishi Rayon Co., Ltd, 1997, 168-169
- POLYMER HANDBOOK. John Wiley & Sons, Inc, 1989, 209-277